# DEMANDE DE BREVET EUROPEEN

(11) **EP 0 658 002 A1**
(43) Date de publication de la demande: **14.06.1995**
(21) Numéro de dépôt: 94402790.3
(22) Date de dépôt: 06.12.1994
(51) Int. Cl.: H03K 17/18

(54) **Procédé et dispositif pour extraire un signal indicatif de l'état de charge d'un commutateur de puissance, et dispositifs de commutation et de commande associés**

(30) Priorité: 08.12.1993 FR 9314743
(71) Demandeur: EURO CP s.a.r.l., F-94100 Saint Maur (FR)
(72) Inventeur: Gilbert, Jérôme, F-92300 Levallois Perret (FR)
(74) Mandataire: Pontet, Bernard

(57) **Abrégé**

Procédé pour extraire un signal indicatif de l'état de charge d'un composant commutateur de puissance (6) disposé entre une charge (2) et une source d'alimentation électrique alternative (N, P), le procédé utilisant une alimentation par des moyens d'alimentation auxiliaire (13).

Le procédé comprend les étapes suivantes :
- une étape d'extraction d'un signal représentatif de la tension aux bornes du composant commutateur (6), et
- une étape de mise en forme dudit signal extrait pour délivrer un signal (S) apte à être traité ultérieurement, cette étape de mis en forme utilisant l'alimentation auxiliaire (13).

Ces étapes d'extraction et de mise en forme sont fonctionnelles quel que soit l'état de la charge (2).

Application en domotique, notamment en association avec des procédés des gestion d'énergie électrique.

## Description

La présente invention concerne un procédé pour extraire un signal indicatif de l'état de charge d'un commutateur de puissance, ainsi qu'un dispositif d'extraction mettant en oeuvre ce procédé.

Elle vise également des dispositifs de commutation et de commande incluant un ou plusieurs dispositifs d'extraction selon l'invention.

De nombreux équipements électriques incorporent un ou plusieurs commutateurs de puissance intercalés entre des charges et une source d'alimentation électrique.

Pour commuter une charge de puissance en courant alternatif, il est très souvent nécessaire de faire coïncider les instants où le dispositif de commutation change d'état avec des instants précis de la forme d'onde du courant d'alimentation.

Par exemple, lorsqu'il s'agit de commander une charge en tout ou rien, il est conseillé de fermer un commutateur au passage à zéro de la tension aux bornes de la charge.

Pour réduire le niveau des perturbations réinjectées sur le réseau d'alimentation, il est également conseillé de faire en sorte qu'il y ait un nombre pair de demi-alternances entre les instants d'ouverture et de fermeture du dispositif de commutation. Ceci devient impératif avec des charges de nature inductive dans lesquelles de l'énergie magnétique est stockée, par exemple des transformateurs de forte puissance.

Lorsqu'il s'agit de faire varier la puissance dans une charge et que la faible inertie de cette charge ne permet pas d'employer la technique de commande par trains d'alternance, on utilise généralement la commande dite par variation d'angle de phase.

Cette technique repose sur le changement d'état du commutateur à des instants choisis de la forme d'onde du courant de manière à faire varier la puissance moyenne fournie à la charge en fonction du choix de ces instants.

Par exemple, dans le cas de dispositifs de commutation à base de structures de thyristors tels que des triacs ou alternistors, il suffit de s'occuper de l'instant où l'on va choisir de fermer le commutateur, étant donné que son ouverture est automatique au passage à zéro de la forme d'onde du courant. Avec d'autres dispositifs tels que les GTO (Gate Turn Off), dans lesquels il est possible de commander le commutateur à l'ouverture, une gestion plus sophistiquée peut être envisagée.

Les dispositifs de commutation tels que les triacs ont la particularité de présenter un effet de verrouillage de l'état fermé à partir de l'instant de l'application d'une impulsion de commande de fermeture jusqu'au passage au zéro de courant suivant.

Ce verrouillage n'est assuré que si le courant circulant dans la charge est supérieur à une valeur caractéristique de chaque type de commutateur et suppose que l'impulsion de commande soit suffisamment énergétique.

Cette caractéristique peut avantageusement être mise à profit pour réduire la puissance nécessaire pour alimenter le dispositif de commande du commutateur. Il suffit pour cela de bien maîtriser l'instant d'application de l'impulsion de commande et l'énergie injectée dans le dispositif de commutation pour la commande.

Des dispositifs connus permettent d'obtenir un signal de synchronisation en phase avec la tension d'alimentation alternative. Cette solution pose des problèmes lorsqu'on souhaite rendre son comportement indépendant de l'impédance de la charge. On connaît aussi des dispositifs de commande de triac qui présentent l'inconvénient de ne plus générer de signal de commande lorsque la charge est débranchée. Dans ces dispositifs, l'absence de charge est détectée mais on ne peut pas transmettre l'information d'absence à l'extérieur de ces dispositifs.

Le but de l'invention est de remédier à ces inconvénients en proposant un procédé d'extraction qui puisse être opérationnel quel que soit l'état de la charge et du commutateur.

Suivant l'invention, le procédé pour extraire un signal indicatif de l'état de charge d'un composant commutateur de puissance disposé entre une charge et une source d'alimentation électrique alternative, procédé dans lequel on utilise une alimentation par des moyens d'alimentation auxiliaire, est caractérisé en ce qu'il comprend des étapes suivantes :
- une étape d'extraction d'un signal représentatif de la tension aux bornes du composant commutateur, et
- une étape de mise en forme dudit signal extrait pour délivrer un signal apte à être traité ultérieurement, cette étape de mise en forme incluant une alimentation par les moyens auxiliaires,

et en ce que ces étapes d'extraction et de mise en forme sont fonctionnelles quel que soit l'état de la charge.

Ainsi, avec le procédé selon l'invention, la synchronisation de la commande du dispositif de commutation est effectuée par extraction d'un signal en phase avec la tension présente aux bornes de ce dispositif de commutation ; de ce fait, le comportement global du système est alors indépendant de l'impédance de la charge.

Dans une forme préférée de réalisation de l'invention, mise en oeuvre pour la commande d'un commutateur de puissance, notamment un triac, les étapes d'extraction et de mise en forme sont suivies d'une étape de synchronisation agencée pour générer un signal de synchronisation de la commande dudit commutateur de puissance, ce signal de synchronisation étant valide quel que soit l'état du commutateur de puissance.

Dans une autre forme préférée de réalisation de l'invention, les étapes d'extraction et de mise en forme sont agencées pour générer un signal indicatif de l'absence et de la présence de la charge de puissance.

En particulier, avec le procédé selon l'invention, l'absence de charge est détectée parce que la différence de potentiel aux bornes du commutateur, par exemple le triac, disparaît, mais l'information peut être transmise grâce à la permanence du fonctionnement des moyens d'extraction rendue possible par une alimentation séparée qui n'est donc pas affectée par une coupure dans la charge.

Ainsi, l'étape de détection peut comprendre une étape de comparaison du signal de synchronisation avec un signal de référence, notamment un signal carré sensiblement de même fréquence et de même rapport cyclique que la tension de la source d'alimentation alternative.

Cette étape de détection peut comprendre en outre une étape pour détecter une présence de charge lorsqu'il existe une similitude significative entre le signal de synchronisation et le signal de référence. Lorsque ce procédé est mis en oeuvre notamment pour un composant commutateur commandé à l'état fermé par un signal de commande permanent, l'étape de détection comprend de préférence une étape pour détecter une absence de charge lorsqu'il existe une différence significative entre le signal de synchronisation et le signal de référence.

Lorsque ce procédé est mis en oeuvre pour un composant commutateur commandé par des impulsions de commande, l'étape de détection comprend en outre de préférence une étape pour détecter une absence de charge lorsque la forme d'onde du signal de synchronisation diffère de celle du signal de référence par l'existence, au moins sur une demi-alternance, d'une altération de cette forme d'onde, cette altération étant induite par au moins une impulsion de commande.

Le procédé selon l'invention exploite le fait que les dispositifs de commutation électrique ne sont pas des commutateurs parfaits car ils présentent une différence de potentiel à leurs bornes à l'état fermé. Cette différence de potentiel est mise en forme pour constituer un signal apte à être traité par le dispositif de commande associé au commutateur lorsqu'il est à l'état fermé. Une autre caractéristique de l'invention est de fournir un signal de synchronisation en tout point identique quel que soit l'état du commutateur. Lorsque le commutateur est à l'état ouvert, aucun courant ne circule dans la charge (excepté le courant de fuite du commutateur, dont l'intensité est négligeable). La tension aux bornes du commutateur est donc pratiquement égale à la tension d'alimentation.

Suivant un autre aspect de l'invention, il est proposé un dispositif pour extraire un signal indicatif de l'état de charge d'un composant commutateur de puissance disposé entre une charge de puissance et une source d'alimentation électrique alternative, pour la mise en oeuvre du procédé selon l'invention, alimenté par des moyens auxiliaires d'alimentation électrique, caractérisé en ce qu'il comprend des moyens pour extraire un signal représentatif de la tension aux bornes du commutateur de puissance et des moyens pour mettre en forme le signal extrait et générer un signal apte à être traité par des moyens de commande, ces moyens de mise en forme étant reliés aux moyens auxiliaires d'alimentation électrique.

Le dispositif selon l'invention doit en pratique fonctionner avec une tension faible lorsque la commutation est à l'état fermé, par exemple 1 ou 2 volts efficaces. Mais lorsque le commutateur est à l'état ouvert, le dispositif selon l'invention doit résister à une tension beaucoup plus élevée, par exemple 230 Volts efficaces, et rester fonctionnel.

Selon un autre aspect de l'invention, le dispositif de commutation intercalé entre une charge et une source d'alimentation électrique alternative, comprenant des moyens de commutation présentant une première borne reliée à une borne de la charge et une seconde borne reliée à un pôle de ladite source d'alimentation électrique et comprenant une électrode de commande, est caractérisé en ce qu'il comprend en outre un dispositif d'extraction selon l'invention relié d'une part aux bornes des moyens de commutation et d'autre part à des moyens auxiliaires d'alimentation électrique, ce dispositif d'extraction comprenant une borne de sortie pour délivrer un signal de sortie indicatif de l'état de charge des moyens de commutation.

Le dispositif de commutation selon l'invention fournit un signal en phase avec la tension aux bornes du commutateur et d'amplitude constante, par exemple 5 Volts, quel que soit l'état du commutateur.

Par ailleurs, il existe de nombreuses applications qui pourraient tirer parti d'une information relative à la présence ou l'absence d'une charge entre le dispositif de commutation et le pôle de l'alimentation qui n'est pas connecté au commutateur.

Selon encore un autre aspect de l'invention, le dispositif pour commander l'alimentation d'un équipement électrique à partir d'une source d'alimentation électrique alternative, est caractérisé en ce qu'il comprend un dispositif de commutation selon l'invention disposé entre la charge et la source d'alimentation électrique, des moyens de contrôle et de traitement, des moyens pour transmettre des informations de commande entre un site à distance et les moyens de contrôle et de traitement, des moyens pour générer un signal de commande appliqué sur la borne de commande des moyens de commutation inclus dans le dispositif de commutation et des moyens auxiliaires pour alimenter les moyens de transmission, les moyens de contrôle et de traitement et les moyens pour générer un signal de commande, les moyens de contrôle et de traitement recevant en entrée le signal de sortie généré par le dispositif de commutation et générant en sortie un signal de commande appliqué aux moyens de génération de commande.

On peut citer par exemple le cas de l'éclairage où la disponibilité de cette information permettrait de rendre compte automatiquement à distance de la nécessité de changer une ampoule dont le filament est rompu avec la possibilité de préciser la localisation de l'ampoule concernée. On peut également citer le cas de dispositifs électromécaniques pouvant évoluer entre deux butées et dont l'arrivée en fin de course provoque la déconnexion de l'actionneur qui assurait le mouvement. On peut citer à titre d'exemple, les dispositifs de fermeture tels que les volets roulants électriques, les portes ou stores motorisés, les vannes, etc.

L'information de détection de présence et d'absence de charge peut en particulier être utilisée dans le cadre de la mise en oeuvre d'un procédé pour commander un organe actionneur d'un unité fonctionnelle tel que divulgué dans la demande de brevet européen 92 401 718.9 au nom du présent déposant.

Dans un dispositif de commande selon l'invention assurant une fonction de détection de présence ou d'absence de charge, les moyens de contrôle et de traitement comprennent des moyens pour comparer le signal de synchronisation à un signal carré de référence synchrone de la tension d'alimentation alternative. Ceci peut être en pratique réalisé au sein d'un microcontrôleur.

Dans une première forme de réalisation d'un dispositif de commande selon l'invention, lorsqu'il s'agit de commander un composant commutateur recevant un signal de commande permanent à l'état fermé, les moyens de contrôle et de traitement comprennent en outre des moyens pour détecter la présence d'une charge, ces moyens de détection de présence coopérant avec les moyens de comparaison pour détecter un signal de synchronisation présentant un rapport cyclique sensiblement égal à 50%.

Dans une seconde forme de réalisation d'un dispositif de commande selon l'invention, lorsqu'il s'agit de commander un composant commutateur recevant des impulsions de commande, les moyens de contrôle et de traitement comprennent en outre des moyens pour détecter l'absence d'une charge, ces moyens de détection d'absence coopérant avec les moyens de comparaison pour détecter un signal de synchronisation présentant sur sa forme d'onde des altérations coïncidant avec des impulsions de commande.

Le procédé selon l'invention permet d'extraire l'information de présence de charge à partir du signal de synchronisation de la façon suivante :
- lorsque la charge est présente, le dispositif selon l'invention délivre un signal de synchronisation pratiquement de même période et de même rapport cyclique que la tension d'alimentation quel que soit l'état du commutateur.

Lorsque la charge est absente, le dispositif selon l'invention génère un signal qui n'est plus conforme en période et/ou en rapport cyclique à la tension d'alimentation qui présente des caractéristiques connues, par exemple un rapport cyclique de ½ et une fréquence moyenne de 50 ou 60 Hz. Il est relativement aisé avec des moyens classiques en logique câblée ou programmée de traiter le signal issu du dispositif selon l'invention pour délivrer l'information de synchronisation et/ou l'information de présence de charge.

On peut également prévoir une forme particulière du procédé selon l'invention, mise en oeuvre pour un composant commutateur commandé par des impulsions de commande, dans laquelle l'étape de détection comprend en outre une étape pour détecter une absence de charge lorsque la forme d'onde du signal de synchronisation diffère de celle du signal de référence par l'existence, au moins sur une demi-alternance, d'une altération de cette forme d'onde, cette altération étant induite par au moins une impulsion de commande.

Suivant encore un autre aspect de l'invention, il est proposé un dispositif pour commander l'alimentation électrique d'un organe actionneur comprenant plusieurs enroulements d'alimentation à partir d'une source d'alimentation alternative, caractérisé en ce qu'il comprend plusieurs dispositifs de commutation selon l'invention disposés chacun, d'une part, entre une première borne d'un enroulement dont la seconde borne est reliée à un premier pôle de la source d'alimentation et, d'autre part, un second pôle de ladite source d'alimentation, des moyens de contrôle et de traitement recevant des signaux de sortie générés par chaque dispositif de commutation et émettant des signaux pour commander chaque dispositif de commutation, des moyens pour transmettre des informations entre un site à distance et les moyens de contrôle et de traitement et des moyens pour alimenter les moyens de transmission, les moyens de contrôle et de traitement et le dispositifs de commutation.

D'autres particularités et avantages de l'invention apparaîtront entre dans la description ci-après. Aux dessins annexés donnés à titre d'exemples non limitatifs:
- la figure 1 illustre un mode particulier de réalisation d'un dispositif d'extraction selon l'invention associé à un dispositif de commutation tel qu'un triac ;
- la figure 2 représente une première application d'un dispositif de commande selon l'invention mis en oeuvre dans un système de réglage d'intensité lumineuse ;
- la figure 3 illustre une seconde application d'un dispositif selon l'invention pour la commande d'un actionneur ;
- la figure 4 représente une première forme d'onde d'un signal généré par un dispositif d'extraction selon l'invention en présence d'une charge ;
- la figure 5 représente une seconde forme d'onde d'un signal généré par un dispositif d'extraction selon l'invention en l'absence de charge ;
- la figure 6 représente une première forme d'onde d'un signal généré par un dispositif d'extraction selon l'invention en présence d'une charge et d'impulsions de commande du commutateur; et
- la figure 7 représente une seconde forme d'onde d'un signal généré par un dispositif d'extraction selon l'invention en l'absence de charge et en présence d'impulsions de commande du commutateur.

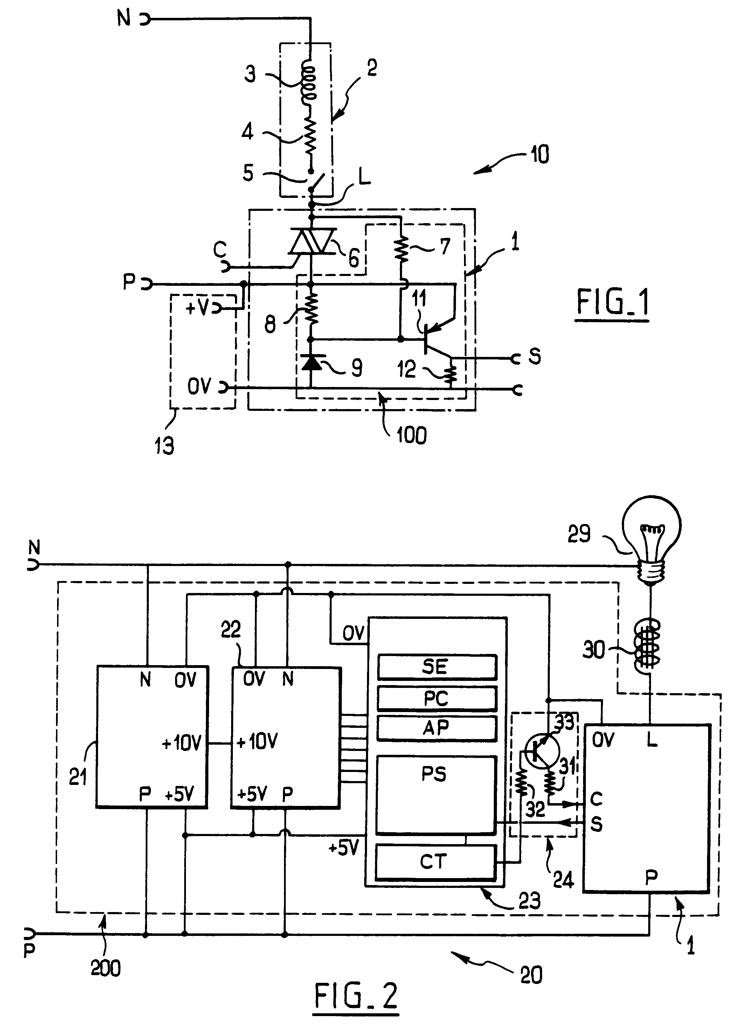

On va maintenant décrire un mode de mise en oeuvre d'un dispositif d'extraction selon l'invention en référence à la figure 1.

Le système de puissance 10 représenté en figure 1 comprend une charge 2, par exemple de nature inductive, modélisable par exemple par une inductance 3, une résistance 4 et un interrupteur 5, et un dispositif de commutation 1 comprenant un commutateur de puissance 6 de type triac présentant une gâchette de commande sur laquelle est appliqué un signal de commande C et un dispositif d'extraction 100 selon l'invention directement associé au triac 6. Ce triac 6 est intercalé entre une alimentation de puissance alternative présentant deux pôles N, P et la charge 2 à laquelle le triac 6 est relié par une borne de charge L. La charge 2 peut être de nature plus ou moins inductive selon l'importance de la composante inductive 3 par rapport à la composante résistive 4. Cette charge 2 peut être présente (interrupteur 5 fermé) ou absente (interrupteur 5 ouvert) . Une alimentation auxiliaire 13 délivre une tension continue +V sur une borne reliée à l'un des pôles P de la source d'alimentation alternative et à l'anode du triac 6, la masse 0V de cette alimentation auxiliaire étant reliée à la masse du dispositif d'extraction 100 selon l'invention. Un transistor 11, par exemple un transistor bipolaire de type PNP, présentant de préférence de bonnes caractéristiques de sensibilité et de commutation, assure la mise en forme d'un signal extrait pour qu'il puisse être traité sous la forme d'un signal logique S par une logique de traitement (non représentée en figure 1) qui sera décrite ultérieurement. A titre d'exemple, la mise en forme du signal comprend l'obtention de fronts raides et d'une amplitude prédéterminée, par exemple égale à 5 volts. Le signal brut extrait est prélevé aux bornes du triac 6 par la résistance 7 qui forme avec la résistance 8 un pont diviseur de courant assurant une commande correcte du transistor 11. Les valeurs respectives des résistances 7 et 8 doivent être choisies en fonction des caractéristiques du transistor 11, selon des considérations classiques de polarisation d'un transistor. On peut d'ailleurs, pour un transistor 11 de bonne qualité, prévoir de supprimer la résistance 8, et de n'utiliser qu'une résistance 7 placée entre une première borne du triac 6 et la base du transistor 11, la seconde borne du triac 6 étant alors reliée à l'émetteur du transistor 11. La diode 9 assure l'écrêtage des tensions négatives aux environs du potentiel 0 Volt et protège ainsi le transistor 11 contre les trop grandes excursions de tension aux bornes du transistor. La résistance 12, choisie par exemple égale à 220kΩ, fixe le potentiel de sortie à 0 Volt lorsque le transistor 11 est à l'état bloqué.

Le dispositif d'extraction selon l'invention qui vient d'être décrit peut être mis en oeuvre dans un dispositif de commutation 1 au sein d'un dispositif 20 de gestion d'une source d'éclairage à incandescence commandable à distance et capable d'informer des dispositifs distants en cas de rupture du filament, dont l'architecture interne est décrite à titre d'exemple en figure 2. Le dispositif de gestion d'éclairage 20 comprend une ampoule 29 qui constitue la charge et un dispositif de commande 200 incluant le dispositif de commutation 1.

Le dispositif de commutation 1, semblable à celui qui vient d'être décrit en référence à la figure 1, est disposé entre la charge 29 et une source d'alimentation alternative N, P à laquelle sont également reliés un dispositif d'alimentation auxiliaire 21, un dispositif de transmission par courants porteurs 22, une unité de contrôle et de traitement 23, par exemple un microcontrôleur, et un circuit 24 pour générer un signal de commande du triac à partir d'un signal logique émis par l'unité de contrôle et de traitement 23. Le dispositif d'alimentation auxiliaire 21 est prévu pour délivrer plusieurs niveaux de tension continue, par exemple un niveau de tension de +5 Volts et un niveau de tension de +10 Volts, destinés aux différents composants du dispositif de commande 200. Le circuit générateur 24 peut comprendre classiquement un transistor 33, par exemple un transistor bipolaire NPN, une résistance de base 32 reliant la base du transistor 33 à une sortie de commande de l'unité de contrôle et de traitement 23 et une résistance de collecteur 31 reliant le collecteur du transistor 33 à l'entrée de commande C du dispositif de commutation 1, l'émetteur du transistor 33 étant relié à la masse du dispositif de commande 200.

L'unité de contrôle et de traitement 23 comprend classiquement une mémoire non volatile comprenant plusieurs modules logiciels, notamment :
- un système d'exploitation SE,
- un protocole de communication PC,
- un module d'application AP,
- un module PS implémentant le procédé d'extraction selon l'invention, et notamment les fonctions de synchronisation et de détection de présence/absence de charge, et
- un module de commande du commutateur de puissance, pour générer un signal de commande.

On peut prévoir d'intercaler un dispositif de filtrage 30 entre la charge, en l'occurrence l'ampoule 29, et la sortie L du dispositif commutateur 1, afin de réduire le niveau de parasite réinjecté sur le réseau d'alimentation lorsque les possibilités de variation de puissance sont exploitées.

En cas de disparition de la charge, c'est à dire en cas de rupture du filament de l'ampoule 29, un message indicatif de cet événement et éventuellement de la localisation de l'ampoule concernée est transmis par le dispositif de transmission 22 via le réseau électrique par courants porteurs vers un système de commande à distance (non représenté) après chaque tentative d'allumage.

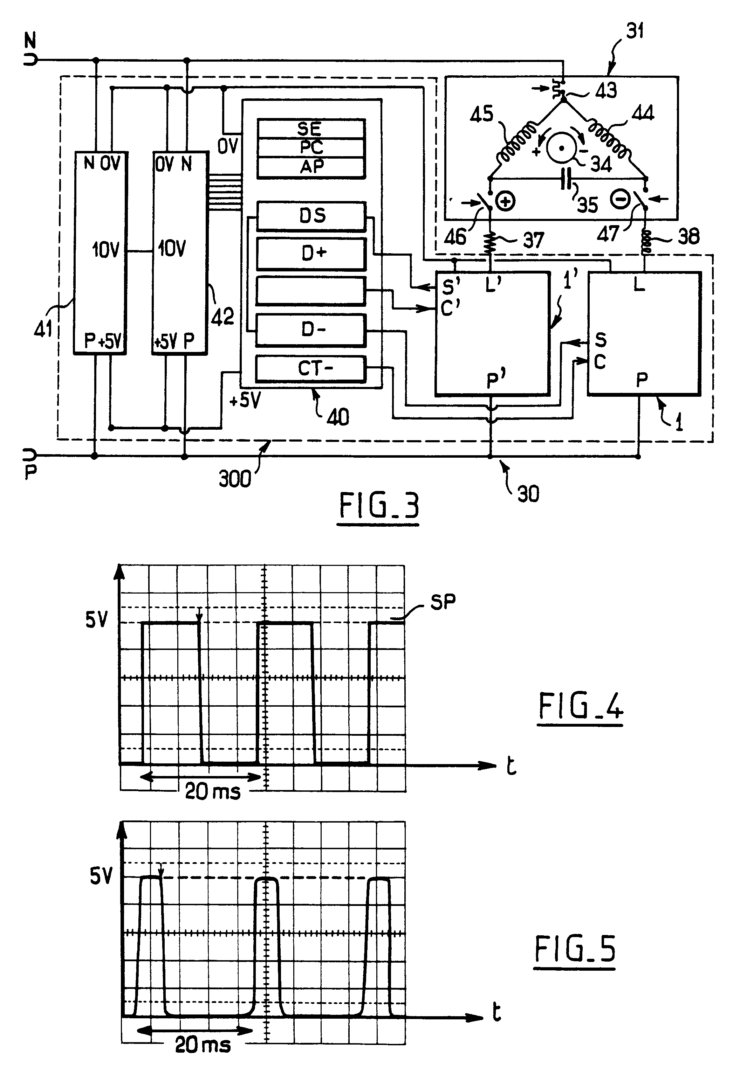

On peut également prévoir la mise en oeuvre de deux dispositifs de commutation 1, 1' selon l'invention au sein d'un dispositif de commande 300 d'un organe actionneur 31 évoluant entre deux butées dont l'arrivée en fin de course provoque la déconnexion de l'actionneur concerné, l'ensemble commande 300/actionneur 31 constituant un système de motorisation intelligent 30, en référence à la figure 3. Le dispositif de commande 300 comprend en outre un dispositif d'alimentation auxiliaire 41, un dispositif de transmission d'informations par courants porteurs 42 et une unité de contrôle et de traitement 40, par exemple un microcontrôleur. Le dispositif d'alimentation auxiliaire 41 et le dispositif de transmission 42 peuvent être choisis semblables à ceux décrits en figure 2. L'unité de contrôle et de traitement 40 comprend une mémoire non volatile comportant plusieurs modules logiciels, notamment :
- un système d'exploitation SE,
- un protocole de communication PC,
- un module d'application AP,
- un module DS de détection de sécurité thermique,
- un module D+ de détection de fin de course dans le sens positif,
- un module CT+ de commande de triac dans le sens positif,
- un module D- de détection de fin de course dans le sens négatif,
- un module CT- de commande de triac dans le sens négatif.

Les modules logiciels D+ et D- de détection de fin de course sont conçus pour recevoir et traiter des signaux de sortie S', S issus respectivement des dispositifs de commutation 1', 1, tandis que les modules logiciels CT+ et CT- de commande de triac sont conçus pour générer des signaux de commande C', C et les appliquer respectivement aux dispositifs de commutation 1', 1.

L'actionneur est par exemple un moteur asynchrone monophasé 34 présentant un premier enroulement 45 et un second enroulement 44 ayant en commun une première borne reliée via un contact de sécurité thermique 43 à un pôle N de l'alimentation alternative. Les secondes bornes respectives de chaque enroulement 45, 44 sont reliées d'une part, respectivement via des interrupteurs de fin de course 46, 47 aux bornes de charge respectives L', L des dispositifs de commutation respectifs 1', 1 et d'autre part, aux bornes d'un condensateur de déphasage 35. Un élément résistif 37 et un élément inductif 38 sont classiquement insérés entre les bornes de charge L', L et les bornes du condensateur de déphasage 35, afin de protéger les deux triacs équipant les deux dispositifs de commutation 1', 1 en cas d'amorçage simultané accidentel.

Le contact de sécurité 43 tel qu'un contact thermique ou de dépassement de couple etc, qui est notamment prévu dans le cas de volets roulants électriques, se déclenche en cas de surchauffe causée par une utilisation trop intensive ou en cas de blocage mécanique. Il est aisé de détecter le passage en coupure de sécurité par le procédé d'extraction selon l'invention et il faut noter que, pour cette application, c'est le seul cas où l'on détecte une disparition de charge simultanément dans les deux branches de puissance. Le microcontrôleur est de préférence programmé pour identifier l'ouverture du contact de sécurité lorsqu'il reçoit de la part de tous les dispositifs de commutation des signaux simultanés de détection d'absence de charge.

Le dispositif de commande 30 permet de commander à distance par exemple un volet roulant à qui on peut transmettre une consigne d'ouverture ou de fermeture entre 0 et 100 %. L'apprentissage de la durée du déplacement total entre les deux butées ainsi que les recalages périodiques sont des opérations entièrement automatisées grâce à la détection de fin de course par disparition de charge en cours de déplacement.

On va maintenant expliquer le fonctionnement d'un dispositif d'extraction selon l'invention mis en oeuvre pour la détection de présence et d'absence d'une charge, en référence aux figures 4 et 5, ce dispositif d'extraction présentant par un exemple une structure du type de celle représentée en figure 1.

Lorsqu'une charge est présente, le dispositif selon l'invention génère un signal SP tel que représenté à titre d'exemple sur la figure 4, qui n'est pas modifié par un changement d'état du dispositif de commutation. Dans cet exemple, la tension d'alimentation est égale à 230 volts efficace avec une fréquence de 50 Hz et un rapport cyclique de 50 %. On peut observer que le signal SP généré par le dispositif selon l'invention est conforme en fréquence et en rapport cyclique à la tension d'alimentation. L'amplitude de ce signal est ici égale à 5 volts de manière à pouvoir être appliqué à un dispositif de commande standard.

Le signal généré par le dispositif d'extraction selon l'invention est nul dans les situations suivantes:
A.
   - commutateur ouvert ou fermé,
   - charge absente, câble court et capacités parasites négligeables,
   - commande du triac par impulsions de très courte durée, par exemple 20 µs,
B.
   - commutateur ouvert
   - charge absente, câble court,
   - commande du triac par courant de gâchette permanent pendant la durée de fermeture du triac.

Le signal généré par le dispositif d'extraction selon l'invention est au niveau haut, par exemple à +5 volts dans les situations suivantes :
- commutateur fermé,
- charge absente, câble avec ou sans capacité parasite,
- commande du triac par courant de gâchette appliqué en permanence pendant la durée de fermeture du commutateur.

Le signal généré par le dispositif d'extraction selon l'invention présente une forme d'onde périodique de rapport cyclique inférieur à 50 %, représentée en figure 5, dans les situations suivantes :
A.
   - commutateur ouvert ou fermé,
   - charge absente mais câble présentant des capacités parasites non négligeables,
   - commande du triac par impulsions de très courte durée, par exemple 20 µs,
B.
   - commutateur ouvert
   - charge absente mais câble présentant des capacités parasites non négligeables,
   - commande du triac par courant de gâchette appliqué en permanence pendant la durée de fermeture du commutateur.

L'existence de capacités parasites significatives dans le câble reliant la charge de puissance au commutateur et au pôle de l'alimentation alternative qui n'est pas relié au commutateur a pour effet de produire un signal périodique à faible rapport cyclique tel que représenté en figure 5.

Le procédé d'extraction selon l'invention peut être aisément mis en oeuvre comme procédé de détection de présence et d'absence de charge. En effet, seule la situation de présence d'une charge conduit à la génération d'un signal présentant des conditions de fréquence et de rapport cyclique voisines de celles de l'alimentation alternative. Dans le cas de la commande d'un triac avec un courant appliqué de façon permanente pendant la durée de fermeture, la détection de présence et d'absence de charge revient à discriminer un signal alternatif d'un signal à amplitude constante, ce qui ne présente aucune difficulté avec les méthodes classiques de discrimination.

Dans le cas de la commande d'un triac avec des impulsions de très courte durée, si on maîtrise la longueur et la nature du câble reliant le dispositif de commutation à la charge de puissance, on est alors également amené à effectuer une discrimination d'un signal alternatif par rapport à un signal continu.

Si les caractéristiques du câble ne sont pas maîtrisées, on effectue alors une discrimination entre un rapport cyclique de 50 % et un rapport cyclique inférieur. Une technique classique de discrimination consiste à comparer la durée de deux demi-alternances consécutives qui doivent être égales dans le respect d'une certaine tolérance pour signifier la présente d'une charge. Il est également possible de comparer la durée d'une demi-alternance avec une valeur fixe correspondant aux caractéristiques de la tension d'alimentation, par exemple 10 ms dans le cas d'un réseau 50 Hz.

Il est également possible de combiner les deux critères de discrimination précédents pour ne pas avoir à prendre en compte le type de commande du commutateur, ni les caractéristiques du câble de liaison entre le commutateur et la charge.

Par ailleurs, il est possible de réduire l'influence des capacités parasites du câble de liaison en ajoutant un réseau RC de type ``snubber'' aux bornes du triac. Ce réseau, mis en oeuvre de façon classique pour supprimer les problèmes de commutation sur charge inductive, produit des effets secondaires bénéfiques sur le signal du dispositif d'extraction selon l'invention lorsque le commutateur est un triac et lorsqu'une grande longueur de câble présentant des capacités parasites élevées rend difficile la discrimination des signaux associés aux états "charge présente" et "charge absente".

Dans une seconde méthode de détection pouvant être mise en oeuvre dans le cadre du procédé selon l'invention, la détection de l'absence ou de la présence d'une charge aux bornes d'un dispositif de commutation en courant alternatif tel qu'un triac est obtenue en utilisant le fait que ce type de commutateur commandé par impulsion n'est maintenu à l'état fermé après disparition de l'impulsion de commande que si le courant dans la charge dépasse une valeur caractéristique du modèle de commutateur utilisé.

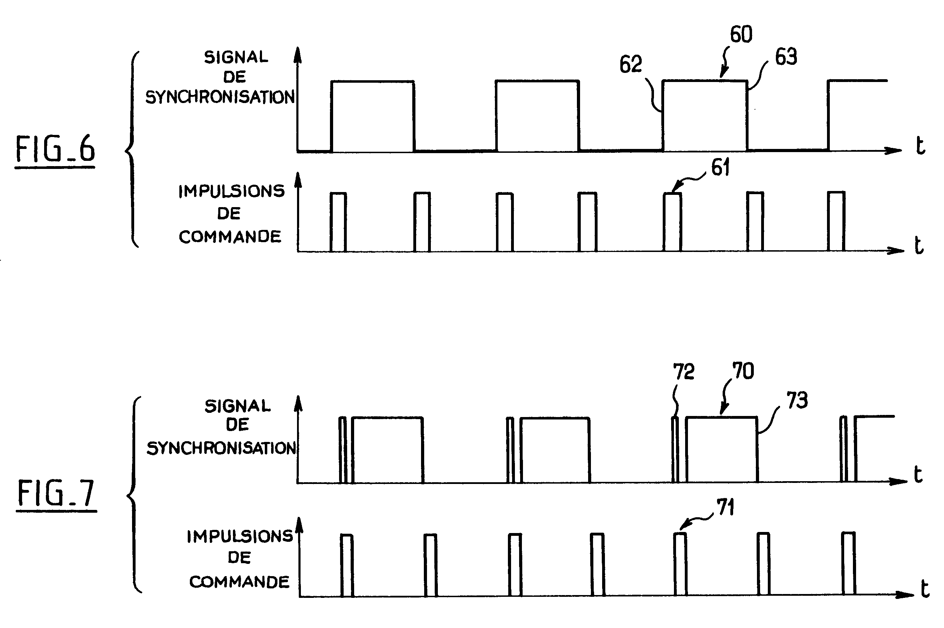

Il suffit alors de tester l'état logique du signal de synchronisation en fonction des instants d'application de l'impulsion de commande. Lorsqu'une charge significative est présente dans le circuit du commutateur, le signal de synchronisation est un signal carré 60 de même période que la tension d'alimentation et de période double de celle des impulsions de commande 61 qui coïncident alternativement avec les fronts montants 62 et descendants 63 du signal de synchronisation, comme l'illustre la figure 6.

En l'absence de charge, les impulsions de commande entraînent le signal de synchronisation à l'état logique opposé au moins toutes les demi-alternances positives ou toutes les demi-alternances négatives. La demi-alternance concernée par cet effet d'entrainement dépend de la technologie du commutateur mis en oeuvre et de la polarité de l'impulsion de commande par rapport à l'électrode de référence du commutateur. Ainsi, en référence à la figure 7, une impulsion de commande sur deux conduit à la génération d'une impulsion très brève 72 sur le signal de synchronisation 70, puis un état logique bas jusqu'à la disparition de l'impulsion de commande 71, suivi d'un état logique haut sur le reste de la demi-alternance concernée et d'un front descendant 73 synchrone avec l'impulsion de commande suivante.

On peut alors prévoir, avec des moyens électroniques classiques, un dispositif de détection apte à détecter l'existence ou non sur le signal de synchronisation de cette impulsion d'entrainement indicatrice de l'absence d'une charge significative. Plus généralement, les impulsions d'entrainement observées sur un signal de synchronisation en l'absence de charge constituent une altération détectable de la forme d'onde de ce signal. On peut d'ailleurs envisager d'autres formes d'altération détectable sur le signal de synchronisation, présentant par exemple une polarité ou une forme différente de celle qui vient d'être décrite.

La seconde méthode de détection de présence/absence de charge qui vient d'être décrite dans le cadre du procédé selon l'invention, met en oeuvre un traitement combiné du signal de synchronisation avec le signal d'impulsions de commande pour détecter la présence ou l'absence de charge. Cette seconde technique est préférée lorsque la puissance des charges à commander est supérieure au courant de maintien du commutateur concerné, c'est à dire, lorsque ce commutateur peut être commandé par impulsion. Cette méthode offre l'avantage de ne pas être perturbée par la longueur des câbles séparant le commutateur de la charge commandée, de pouvoir détecter une absence de charge au secondaire d'un transformateur alors que le primaire est toujours connecté dans le circuit du commutateur, et d'être simple à mettre en oeuvre.

Lorsque la puissance nominale de la charge commandée est telle que le courant la traversant est inférieur au courant de maintien dans le commutateur et donc que ce commutateur ne peut pas être commandé par impulsion, il est alors préférable d'utiliser la première méthode de détection dans le cadre du procédé selon l'invention, qui est basée sur la détection d'une forme d'onde de synchronisation différente d'un signal carré à la fréquence du secteur.

Bien sûr, l'invention n'est pas limitée aux exemples qui viennent d'êtres décrits et de nombreux aménagements peuvent être apportés à ces exemples sans sortir du cadre de l'invention.

Ainsi, l'invention peut être appliquée à des dispositifs de commutation autres qu'un triac. On peut également employer des composants pour la mise en forme du signal extrait autres qu'un transistor bipolaire PNP. De même, on peut envisager bien d'autres dispositifs de protection qu'une diode au silicium.

Par ailleurs, il est possible de mettre en oeuvre le procédé selon l'invention dans le cadre d'applications liées à la gestion de l'énergie, notamment en combinaison avec un procédé de gestion de puissance électrique dans un réseau domotique tel que divulgué dans le demande de brevet français n°9112604 au nom du présent déposant. Le procédé selon l'invention peut également être associé à des procédés de gestion de tarification de l'énergie électrique et à des procédés de comptage analytique de l'énergie.

L'association du procédé selon l'invention avec ces procédés de gestion d'énergie permet de fournir non seulement l'information de synchronisation nécessaire pour assurer la commutation des charges de puissance dans de bonnes conditions mais également une information de détection de présence ou d'absence d'une charge. Le contrôle de la présence de la charge permet d'envisager la mise en oeuvre de procédés de gestion d'énergie dans des dispositifs "suiveurs" de l'état d'une charge extérieure pour lesquels il n'est plus nécessaire d'avoir un contact direct avec l'utilisateur. Il est ainsi possible de réaliser des appareils d'adaptation de produits existants qui ne nécessitent pas de changement des habitudes d'utilisation tout en offrant les bénéfices de la mise en oeuvre des procédés de gestion concernés.

On reste toujours dans le cadre de l'invention quel que soit le moment où on prend la décision de présence ou d'absence de charge. Cela peut être avant la fermeture du commutateur si le signal extrait révèle l'absence de charge alors que le commutateur est ouvert. Mais dans certains cas, liés notamment à la présence de capacités parasites, l'absence de charge peut être indétectable lorsque le commutateur est ouvert, et n'apparaître que d'après le signal que l'on extrait lorsque le commutateur est à l'état fermé, auquel cas l'invention ne fournit qu'à ce stade l'information "absence de charge".

L'invention a été décrite en combinaison avec l'utilisation des courants porteurs comme moyen de transmission, mais d'autres moyens de transmission, par exemple optiques, radioélectriques ou filaires sont envisageables.

## Revendications

1. Procédé pour extraire un signal (S) indicatif de l'état de charge d'un composant commutateur de puissance (6) disposé entre une charge (2, 31, 29) et une source d'alimentation électrique alternative (N, P), procédé dans lequel on utilise une alimentation par des moyens d'alimentation auxiliaire (13, 21, 41), caractérisé en ce qu'il comprend des étapes suivantes :
- une étape d'extraction d'un signal représentatif de la tension aux bornes du composant commutateur (6), et
- une étape de mise en forme dudit signal extrait pour délivrer un signal (S) apte à être traité ultérieurement, cette étape de mise en forme utilisant l'alimentation par les moyens auxiliaires (13),
et en ce que les étapes d'extraction et de mise en forme sont fonctionnelles quel que soit l'état de la charge (2, 31, 29).

2. Procédé selon la revendication 1, mis en oeuvre dans la commande d'un commutateur de puissance (6), notamment un triac, caractérisé en ce que les étapes d'extraction et de mise en forme sont suivies d'une étape de synchronisation agencée pour générer un signal de synchronisation de la commande (C) dudit commutateur de puissance (6), ce signal de synchronisation restant valide quel que soit l'état du commutateur de puissance (6).

3. Procédé selon l'une des revendications 1 ou 2, caractérisé en ce que les étapes d'extraction et de mise en forme sont suivies d'une étape de détection agencée pour générer un signal indicatif de l'absence et de la présence de la charge de puissance (2, 31, 29).

4. Procédé selon les revendications 2 et 3, caractérisé en ce que l'étape de détection comprend une étape de comparaison du signal de synchronisation avec un signal de référence, notamment un signal carré sensiblement de même fréquence et de même rapport cyclique que la tension de la source d'alimentation alternative.

5. Procédé selon la revendication 4, caractérisé en ce que l'étape de détection comprend en outre une étape pour détecter une présence de charge lorsqu'il existe une similitude significative entre le signal de synchronisation et le signal de référence.

6. Procédé selon la revendication 4, mis en oeuvre notamment pour un composant commutateur commandé à l'état fermé par un signal de commande permanent, caractérisé en ce que l'étape de détection comprend en outre une étape pour détecter une absence de charge lorsqu'il existe une différence significative entre le signal de synchronisation et le signal de référence.

7. Procédé selon la revendication 4, mis en oeuvre notamment pour un composant commutateur commandé par des impulsions de commande, caractérisé en ce que l'étape de détection comprend en outre une étape pour détecter une absence de charge lorsque la forme d'onde du signal de synchronisation diffère de celle du signal de référence par l'existence, au moins sur une demi-alternance, d'une altération de cette forme d'onde, cette altération étant induite par au moins une impulsion de commande.

8. Dispositif (100) pour extraire un signal indicatif de l'état de charge d'un composant commutateur de puissance (6) disposé entre une charge de puissance (2) et une source d'alimentation électrique alternative (N, P), mettant en oeuvre le procédé selon l'une des revendications précédentes, alimenté par des moyens auxiliaires d'alimentation électrique (13), caractérisé en ce qu'il comprend des moyens (7, 8) pour extraire un signal représentatif de la tension aux bornes du commutateur de puissance (6) et des moyens (11, 12) pour mettre en forme le signal extrait et générer un signal (S) apte à être traité par des moyens de commande (23, 40), ces moyens de mise en forme (11, 12) étant reliés aux moyens auxiliaires d'alimentation électrique (13).

9. Dispositif extracteur (100) selon la revendication 8, caractérisé en ce que les moyens de mise en forme comprennent un transistor (11) alimenté par les moyens auxiliaires d'alimentation (13), ce transistor (11) étant commandé par un signal issu des moyens extracteurs (7, 8) et générant un signal (S) représentatif de l'état de charge du commutateur de puissance (6).

10. Dispositif extracteur (100) selon la revendication 9, caractérisé en ce que les moyens d'extraction comprennent une résistance (7) disposée entre une première borne du commutateur de puissance (6) et la base du transistor (11), l'émetteur dudit transistor (11) étant relié à la seconde borne dudit commutateur de puissance (6).

11. Dispositif de commutation (1, 1') intercalé entre une charge (2) et une source d'alimentation électrique alternative (N, P) comprenant des moyens de commutation (6) comprenant une électrode de commande (C) et présentant une première borne (L) reliée à une première borne de la charge (2) dont la seconde borne est reliée à un premier pôle (N) de la source d'alimentation électrique, et une seconde borne reliée au second pôle (P) de ladite source d'alimentation électrique, caractérisé en ce qu'il comprend en outre un dispositif d'extraction (100) selon l'une des revendications 8 à 10 relié d'une part aux bornes des moyens de commutation (6) et d'autre part à des moyens auxiliaires d'alimentation électrique (13), ce dispositif d'extraction (11) comprenant une borne de sortie pour délivrer un signal de sortie (S) indicatif de l'état de charge des moyens de commutation (6).

12. Dispositif (200) pour commander l'alimentation d'un équipement électrique (29) à partir d'une source d'alimentation électrique alternative (N, P), caractérisé en ce qu'il comprend un dispositif de commutation (1) selon la revendication 11 disposé entre la charge (29) et la source d'alimentation électrique (N, P), des moyens de contrôle et de traitement (23), des moyens (22) pour transmettre des informations entre un site à distance et les moyens de contrôle et de traitement (23), des moyens (31, 32, 33) pour générer un signal de commande (C) appliqué sur la borne de commande des moyens de commutation (6) inclus dans le dispositif de commutation (1) et des moyens auxiliaires (21) pour alimenter les moyens de transmission (22), les moyens de contrôle et de traitement (23) et les moyens (31, 32, 33) pour générer un signal de commande (C), les moyens de contrôle et de traitement (23) recevant en entrée le signal de sortie (S) généré par le dispositif de commutation (1) et générant en sortie un signal de commande appliqué aux moyens de génération de commande (31, 32, 33).

13. Dispositif de commande (200) selon la revendication 12, caractérisé en ce que les moyens de transmission (22) consistent en des moyens de transmission par courants porteurs sur le réseau électrique d'alimentation (N, P).

14. Dispositif de commande (200) selon l'une des revendications 12 ou 13, caractérisé en ce que les moyens de contrôle et de traitement (23) sont agencés pour déterminer, à partir du signal de sortie (S) généré par le dispositif de commutation (1) selon la revendication 11, un signal de synchronisation destiné à la commande des moyens de commutation (6).

15. Dispositif de commande (200) selon la revendication 14, caractérisé en ce que les moyens de contrôle et de traitement (23) sont agencés pour en outre détecter, à partir du signal de sortie (S) généré par le dispositif de commutation (6) selon la revendication 11, une information de présence ou absence de la charge (29).

16. Dispositif de commande selon la revendication 15, caractérisé en ce que les moyens de contrôle et de traitement comprennent des moyens pour comparer le signal de synchronisation à un signal de référence, notamment un signal carré sensiblement de même fréquence et de même rapport cyclique que la tension de la source d'alimentation alternative.

17. Dispositif de commande selon la revendication 16, pour commander un composant commutateur recevant un signal de commande permanent à l'état fermé, caractérisé en ce que les moyens de contrôle et de traitement comprennent en outre des moyens pour détecter la présence d'une charge, ces moyens de détection de présence coopérant avec les moyens de comparaison pour détecter une similitude significative entre le signal de synchronisation et le signal de référence.

18. Dispositif de commande selon la revendication 16, pour commander un composant commutateur recevant des impulsions de commande, caractérisé en ce que les moyens de contrôle et de traitement comprennent en outre des moyens pour détecter l'absence d'une charge, ces moyens de détection d'absence coopérant avec les moyens de comparaison pour détecter sur la forme d'onde du signal de synchronisation des altérations induites par des impulsions de commande.

19. Dispositif de commande (200) selon l'une des revendications 15 à 18, appliqué à la commande de l'alimentation d'une ampoule d'éclairage (29), caractérisé en ce que les moyens de contrôle et de traitement (23) sont agencés pour détecter la rupture du filament de l'ampoule et pour transmettre à un site à distance une information indicative de cette rupture de filament via les moyens de transmission (22).

20. Dispositif (300) pour commander l'alimentation électrique d'un organe actionneur (31) comprenant plusieurs enroulements d'alimentation (45, 44) à partir d'une source d'alimentation alternative (N, P), caractérisé en ce qu'il comprend plusieurs dispositifs de commutation (1', 1) selon la revendication 11 disposés chacun, d'une part, entre une première borne des enroulements (45, 44) ayant leurs secondes bornes respectives reliées en commun à un premier pôle (N) de la source d'alimentation et, d'autre part, un second pôle (P) de ladite source d'alimentation, des moyens de contrôle et de traitement (40) recevant des signaux de sortie (S', S) générés par chaque dispositif de commutation (1', 1) et émettant des signaux (C', C) pour commander chaque dispositif de commutation (1', 1), des moyens (42) pour transmettre des informations entre un site à distance et les moyens de contrôle et de traitement (40) et des moyens auxiliaires (41) pour alimenter les moyens de transmission (42), les moyens de contrôle et de traitement (40) et les dispositifs de commutation (1', 1).

21. Dispositif de commande (300) selon la revendication 20, l'organe actionneur comprenant en outre des moyens interrupteurs de sécurité (43) disposés entre les secondes bornes communes des enroulements et le premier pôle (N) de la source d'alimentation, caractérisé en ce que les moyens de contrôle et de traitement sont agencés pour détecter une ouverture des moyens interrupteurs de sécurité à partir d'une réception simultanée de signaux de détection d'absence émis par tous les dispositifs de commutation.

22. Dispositif de commande (300) selon l'une des revendications 20 ou 21, appliqué à la commande d'un organe actionneur asynchrone monophasé (31) comprenant deux enroulements (45, 44) ayant chacun une première borne commune reliée à un premier pôle (N) de la source d'alimentation électrique et leurs secondes bornes respectives reliées respectivement aux bornes d'une condensateur de déphasage (35) qui sont également chacune reliées à une borne d'un contact de fin de course (37, 38), caractérisé en ce que qu'il comprend deux dispositifs de commutation (1', 1) selon la revendication 9 qui ont chacun leur borne de charge (L', L) reliée à l'autre borne de chaque contact de fin de course (37, 38), et en ce que les moyens de contrôle et de traitement (40) sont agencés pour déterminer, à partir des signaux de sortie (S', S) émis par chaque dispositif de commutation (1', 1), des informations de fin de course respectivement dans un premier sens prédéterminé (+) et dans un second sens (-) opposé au premier sens, et pour générer des signaux de commande (C', C) destinés aux moyens de commutation respectifs de chaque dispositif de commutation (1', 1).
